# EUROPEAN PATENT APPLICATION

(11) **EP 1 936 703 A2**
(43) Date of publication of application: **25.06.2008**
(21) Application number: 07024239.1
(22) Date of filing: 13.12.2007
(51) Int. Cl.: H01L 31/18, H01L 31/078, H01L 27/142

(54) **Inverted metamorphic solar cell with bypass diode**

(30) Priority: 21.12.2006 US 614332
(71) Applicant: Emcore Corporation, Somerset, NJ 08873 (US)
(72) Inventor: Sharps, Paul R., Albuquerque NM 87112 (US)
(74) Representative: Wagner, Karl H.

(57) **Abstract**

A method of forming a semiconductor structure including a multijunction solar cell with an upper subcell, a middle subcell, and a lower subcell, by providing first substrate for the epitaxial growth of semiconductor material; forming a first solar subcell on said substrate having a first band gap; forming a second solar subcell over said first subcell having a second band gap smaller than said first band gap; and forming a grading interlayer over said second subcell having a third band gap larger than said second band gap; forming a third solar subcell having a fourth band gap smaller than said second band gap such that said third subcell is lattice mismatched with respect to said second subcell. A bypass diode is further provided in the semiconductor structure with a region of first polarity of the solar cell connected with a region of second polarity of the bypass diode.

## Description

### BACKGROUND OF THE INVENTION

### 1. Field of the Invention

The present invention relates to the field of solar cell semiconductor devices, and particularly to integrated semiconductor structures including a multijunction solar cell and an integral bypass diode.

### 2. Description of the Related Art

Photovoltaic cells, also called solar cells, are one of the most important new energy sources that have become available in the past several years. Considerable effort has gone into solar cell development. As a result, solar cells are currently being used in a number of commercial and consumer-oriented applications. While significant progress has been made in this area, the requirement for solar cells to meet the needs of more sophisticated applications has not kept pace with demand. Applications such as satellites used in data communications have dramatically increased the demand for solar cells with improved power and energy conversion characteristics.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as the payloads become more sophisticated, solar cells, which act as the power conversion devices for the on-board power systems, become increasingly more important.

Solar cells are often fabricated in vertical, multijunction structures, and disposed in horizontal arrays, with the individual solar cells connected together in a series. The shape and structure of an array, as well as the number of cells it contains, are determined in part by the desired output voltage and current.

When solar cells in an array are all receiving sunlight, are or illuminated, each cell in the array will be forward biased and will be carrying current. However, if any of the cells are not illuminated, because of shadowing or damage, those shadowed cells are still in the array circuit and may be forced to become reversed biased in order to carry the current generated by the illuminated cells. This reverse biasing can degrade the cells and can ultimately render the cells inoperable. In order to prevent reverse biasing, a diode structure in parallel with the solar cells in a single multijunction cell is often implemented.

However, when the solar cell is not receiving sunlight, whether because of shading by a movement of the satellite, or as a result of damage to the cell, then resistance exists along the cell path. As solar cells exist in an array, current from illuminated cells must pass through shaded cells. If there were no diode, the current would force its way through the cell layers, reversing the bias of such cells and permanently degrading, if not destroying the electrical characteristics of such cells.

If the cell contains a diode, however, the current can be offered an alternative, parallel path, and the shaded cells will be preserved. The problem with this concept has been the difficulty in creating a diode that is relatively easy to manufacture and which uses a very low level of voltage to turn on and operate.

The purpose of the bypass diode is to draw the current away from the shadowed or damaged cell. The bypass diode becomes forward biased when the shadowed cell becomes reverse biased. Since the solar cell and the bypass diode are in parallel, rather than forcing current through the shadowed cell, the diode draws the current away from the shadowed cell and completes the electrical current to maintain the connection in the next cell.

If a cell is shaded or otherwise not receiving sunlight, in order for the current to choose the diode path, the turn on voltage for the diode path must be less than the breakdown voltage along the cell path. The breakdown voltage along the cell path will typically be at least five volts, if not more. In an implementation utilizing a Schottky bypass diode. The Schottky contact requires a relatively small amount of voltage to "turn on", about 600 millivolts. However, in a multijunction solar cell with a germanium substrate, to pass through the Ge junction the bias of the Ge junction must be reversed, requiring a large voltage. Reversing the bias of the Ge junction requires approximately 9.4 volts, so nearly ten volts are needed for the current to follow the diode path. Ten volts used to reverse the bias of the Ge junction is ten volts less than otherwise would be available for other applications.

The use of bypass diodes in connection with solar cells is known from U. S. Patent Nos. 6,103,970; 6,359,210; 6,600,100; 6,617,508; 6,680,432, 6,864,414; and 7,115,811.

Inverted metamorphic solar cell structures such as described in U.S. Patent No. 6,951,819 and M.W. Wanless et al., Lattice Mismatched Approaches for High Performance, III - V Photovoltaic Energy Converters (Conference Proceedings of the 31st IEEE Photovoltaic Specialists Conference, Jan.3-7, 2005, IEEE Press, 2005) and copending U.S. Patent Application Serial No. 11/445,793 filed June 2, 2006, of the present assignee, present an important starting point for the development of future commercial products with high energy conversion of efficiency.

Prior to the present invention, the materials and fabrication steps disclosed in the prior art have not been described on energy efficient solar cell based on an inverted metamorphic structure with an integral bypass diode.

### SUMMARY OF THE INVENTION

Briefly, and the general terms, the present invention provides a method of manufacturing a solar cell by providing a first substrate; depositing on the substrate a sequence of layers of semiconductor material, including a first region in which at least one layer of the sequence of layers forms at least one layer of a bypass diode to pass current when the solar cell is shaded, and a second region in which the sequence of layers of semiconductor material forms at least one cell of a multijunction solar cell; providing a second substrate over the second region; and removing the first substrate.

The present invention further provides a solar cell with an integral bypass diode including a semiconductor body having a sequence of layers including a first region including; a first solar subcell having a first band gap; a second solar subcell disposed over the first subcell and having a second band gap smaller than the first band gap; a grading interlayer disposed over the second subcell having a third band gap larger than the second band gap, and a third subcell disposed over the interlayer such that the third solar subcell is lattice mis-matched with respect to the second subcell and has a fourth band gap smaller than the third band gap, and a second region including a bypass diode.

In another aspect, the present invention provides a solar cell semiconductor device having a sequence of layers of semiconductor material, including a first region in which the sequence of layers of material forms at least one cell of a multijunction solar cell, and a second region in which the corresponding sequence of layers forms a support for a bypass diode to protect said cell against reverse biasing wherein the sequence of layers in the first region forming the at least one cell and the sequence of layers in the second region forming the support to the bypass diode are identical and wherein each layer in the first region has substantially the same composition and thickness as the corresponding layer in the second region.

The sequence of layers includes a discontinuous lateral conduction layer forming two electronically isolated portions, the first portion making an electrical contact to an active region of said solar cell in one region, and the second portion making electrical contact to an active region of the bypass diode.

A conductive layer is deposited on the sequence of layers; and a conductor connects the second portion and the bypass diode to the conductive layer.

### BRIEF DESCRIPTION OF THE DRAWINGS

These and other features and advantages of this invention will be better and more fully appreciated by reference to the following detailed description when considered in conjunction with the accompanying drawings, wherein:

FIG. 1 is an enlarged cross-sectional view of the solar cell according to the present invention at the end of the process steps of forming the layers of the bypass diode and solar cell on a first substrate;

FIG. 2 is a cross-sectional view of the solar cell of FIG. 1 after the next process step according to the present invention including adhering a surrogate substrate to the top of the structure;

FIG. 3 is a cross-sectional view of the solar cell of FIG. 2 after the next process step according to the present invention depicted including removing the original substrate;

FIG. 4 is a cross-sectional view of the solar cell of FIG. 3 after the next process step according to the present invention including etching a trench so that the semiconductor body is formed into two spaced apart regions;

FIG. 5 is a cross-sectional view of the solar cell of FIG. 4 after the next process step according to the present invention in which certain layers in the left side region are removed, and a step formed in the right side region;

FIG. 6 is another cross-sectional view of the solar cell of FIG. 5 after the next process step according to the present invention in which a dielectric layer is formed over the right side region;

FIG. 7 is a cross-sectional view of the solar cell of FIG. 6 after the next process step according to the present invention in which a portion of the dielectric layer is removed;

FIG. 8 is a cross-sectional view of the solar cell of FIG. 7 after the next process step according to the present invention in which a conductive layer is deposited;

FIG. 9 is a cross-sectional view of the solar cell of FIG. 8 after the next process step according to the present invention in which contact layers are deposited; and

FIG. 10 is a circuit diagram of the solar cell and bypass diode according to the present invention.

### DESCRIPTION OF THE PREFERRED EMBODIMENT

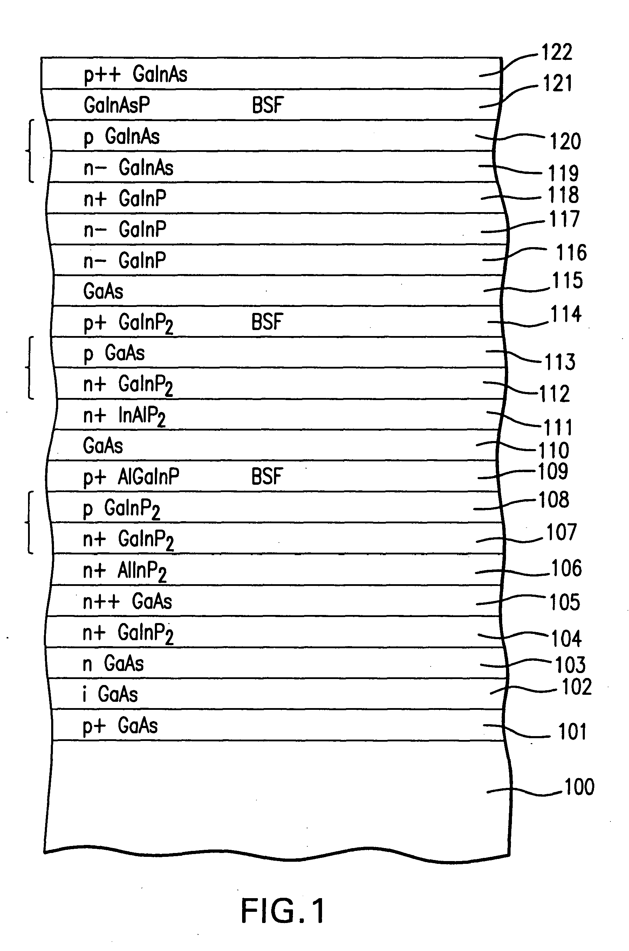

FIG. 1 depicts the multijunction solar cell according to the present invention after formation of the three subcells A, B and C on a substrate. More particularly, there is shown a substrate 100, which may be either gallium arsenide (GaAs), germanium (Ge), or other suitable material. A sequence of layers forming a diode is then deposited on the substrate. For example, a p+ GaAs diode emitter layer 101, an intrinsic GaAs layer 102, and a n type GaAs103 are deposited, followed by an etch stop layer 104 of n+ type GaInP₂. A contact layer 105 of n++ GaAs is then deposited on layer 104, and a n+ AlInP₂ window layer 106 is deposited on the contact layer. The subcell A, consisting of an n+ emitter layer 107 and a p-type base layer 108, are then deposited on the window layer 106.

It should be noted that the multijunction solar cell structure could be formed by any suitable combination of group III to V elements listed in the periodic table subject to lattice constant and band gap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorous (P), arsenic (As), antimony (Sb), and bismuth (Bi).

In the preferred embodiment, the substrate 100 is gallium arsenide, the emitter layer 107 is composed of GaInP₂, and the base layer is composed of p type GaInP₂. The use of the parenthesis in the formula is standard nomenclature to indicate that the amount of aluminum may vary from 0 to 30%.

On top of the base layer 108 is deposited a back surface field ("BSF") layer of p+ type AlGaInP 109 used to reduce recombination loss.

The BSF layer 109 drives minority carriers from the region near the base/BSF interface surface to minimize the effect of recombination loss. In other words, a BSF layer 109 reduces recombination loss at the backside of the solar subcell A and thereby reduces the recombination in the base.

On top of the BSF layer 109 is deposited a sequence of heavily doped p-type and n-type GaAs layers 110 which forms a tunnel diode which is a circuit element to connect cell A to cell B.

On top of the tunnel diode layers 110 a n+ InAlP₂ window layer 111 is deposited. The window layer 111 used in the subcell B also operates to reduce the recombination loss. The window layer 111 also improves the passivation of the cell surface of the underlying junctions. It should be apparent to one skilled in the art, that additional layer(s) may be added or deleted in the cell structure without departing from the scope of the present invention.

On top of the window layer 111 the layers of cell B are deposited: the emitter layer 112, and the p-type base layer 113. These layers are preferably composed of GaInP₂ and GaAs (or In_{0.015}GaAs) respectively, although any other suitable materials consistent with lattice constant and band gap requirements may be used as well.

On top of the cell B a p+ GaInP₂ BSF layer 114 is deposited which performs the same function as the BSF layer 109. A p++/n++ GaAs tunnel diode 115 is deposited over the BSF layer 114 similar to the layers 110, again forming a circuit element to connect cell B to cell C. A buffer layer 116, preferably GaInP, is deposited over the tunnel diode 115, to a thickness of about 1.0 micron. A metamorphic buffer layer 117 is deposited over the buffer layer 116 which is preferably a compositionally step-graded GaInP series of layers with monotonically changing lattice constant to achieve a transition in lattice constant from cell B to subcell C. The bandgap of layer 117 is 1.5 ev constant with a value slightly greater than the bandgap of the middle cell B.

In one embodiment, as suggested in the Wanless et al. paper, the step grade contains nine compositionally graded steps with each step layer having a thickness of 0.25 micron.

On top of the metamorphic buffer layer 117 another n+ GaInAs window 118 is deposited. The window layer 118 improves the passivation of the cell surface of the underlying junctions. Additional layers may be provided without departing from the scope of the present invention.

On top of the window layer 118 the layers of subcell C are deposited; then n+ type emitter layer 119 and the p type base layer 120. In the preferred embodiment, the emitter layer is composed of GaInAs and the base layer is composed of p type GaInAs with about a 1.0 ev bandgap requirements although any other semiconductor material with suitable lattice constant and band gap requirements may be used as well.

On top of the base layer 120 of subcell C a back surface field (BSF) layer 120, preferably composed of GaInAsP, is deposited.

Over or on top of the BSF layer 121 is deposited a p+ contact layer, 122 preferably of p+ type InGaAs.

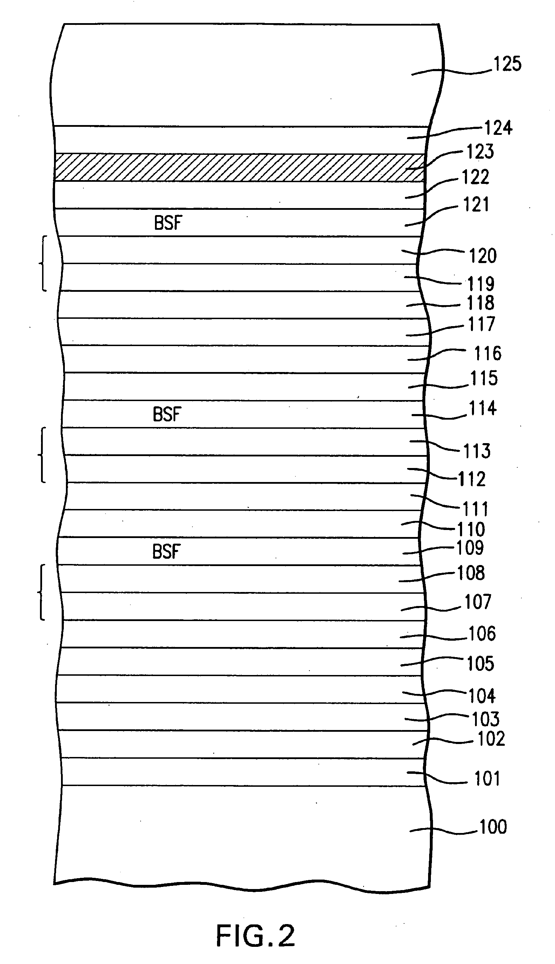

FIG. 2 is a cross-sectional view of the solar cell of FIG. 1 after the next process steps according to the present invention in which a metal contact layer 123 is deposited over the p+ semiconductor contact layer 122. The metal is preferably a sequence of Ti/Au/Ag/Au layers. An adhesive layer 124 is then deposited over the metal layer 123. The adhesive is preferably GenTak 330 (distributed by General Chemical Corp.). A surrogate substrate 125, preferably sapphire, is attached, to the structure using the adhesive layer 124. In the preferred embodiment, the surrogate substrate is about 40 mils in thickness, and is perforated with holes about 1mm in diameter, spaced 4 mm apart, to aid in subsequent removal of the substrate.

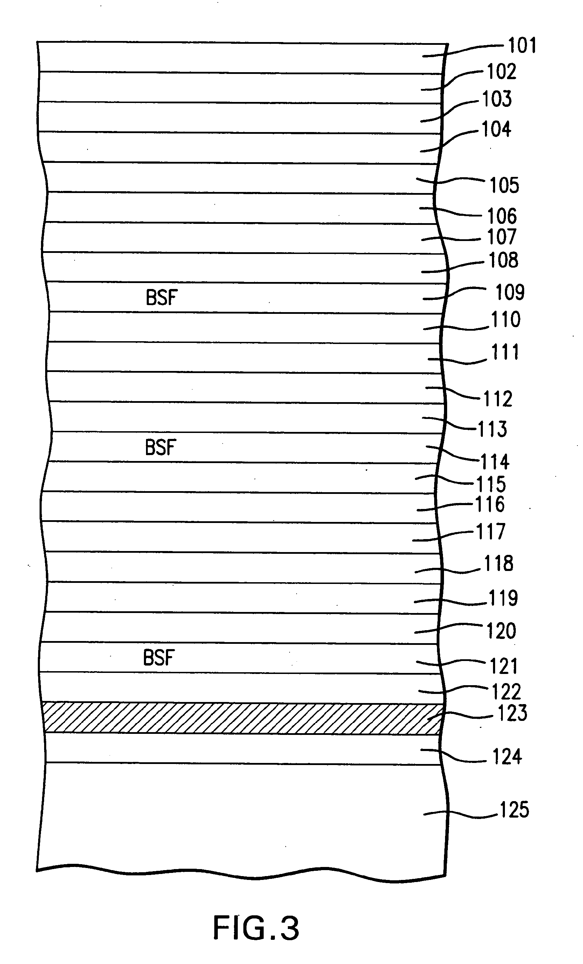

FIG. 3, the structure of FIG. 2 is shown with the surrogate substrate 125 at the bottom. The original substrate 100 is removed by a sequence of lapping and/or etching steps in which the substrate is removed. The choice of the etchant is dependent on the substrate used.

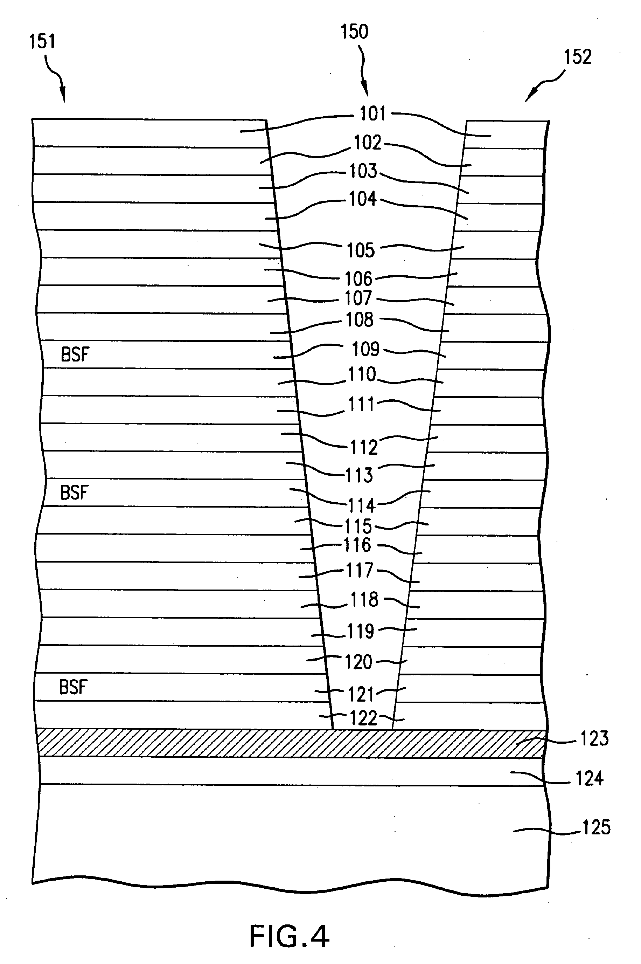

FIG. 4 then depicts the next process steps in which trench 150 is then etched to layer 123 separating the semiconductor body into two regions, 151 and 152. A trench 150 is then etched to layer 123 separating the semiconductor body into two regions, 151 and 152.

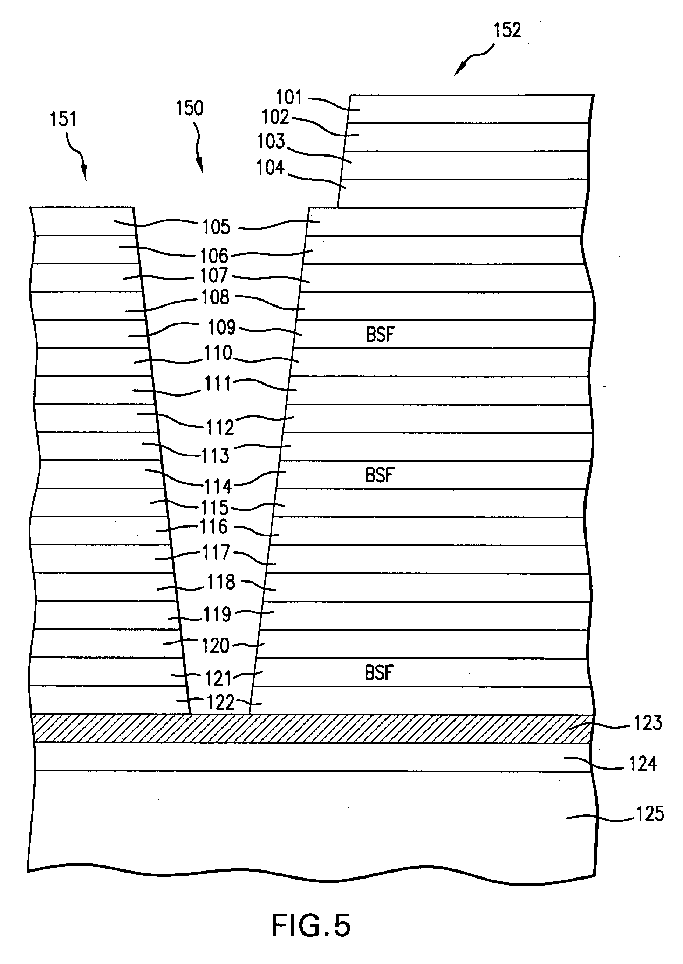

FIG. 5 is a cross-sectional view of the solar cell of FIG. 4 after the next process step according to the present invention in which layers 101 through 104 in the left side region 151 are removed, and a step formed in the right side region 152 between layers 104 and 105. Such processing may be implemented by known photolithography techniques.

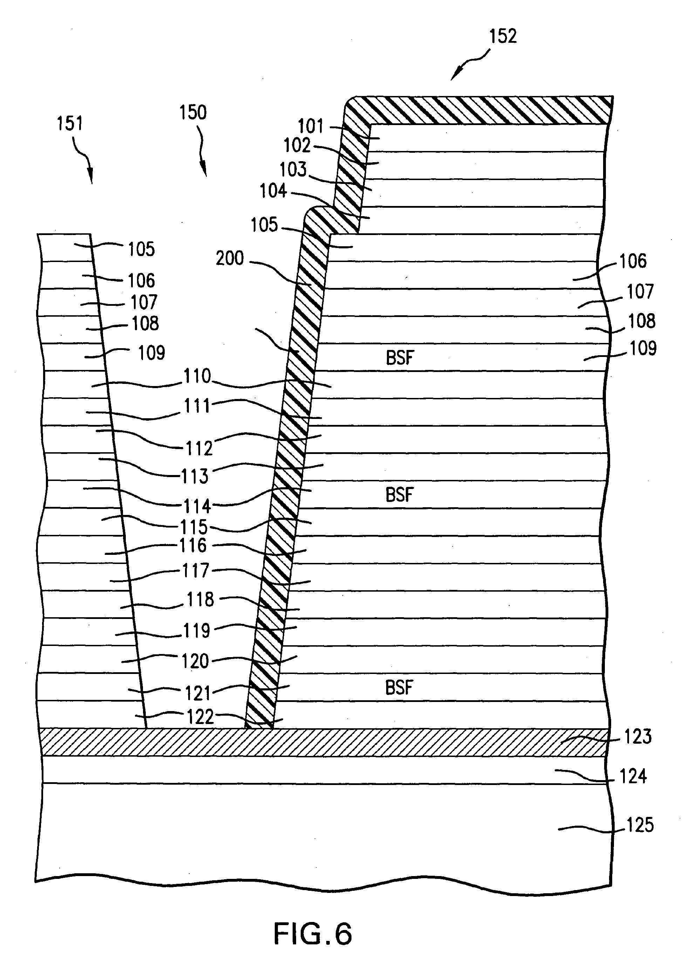

FIG. 6 is another cross-sectional view of the solar cell of FIG. 5 after the next process step according to the present invention in which a dielectric layer 200 is formed over the right side region 152. Such process step may be implemented by known masking, deposition, and photoresist lift off techniques;

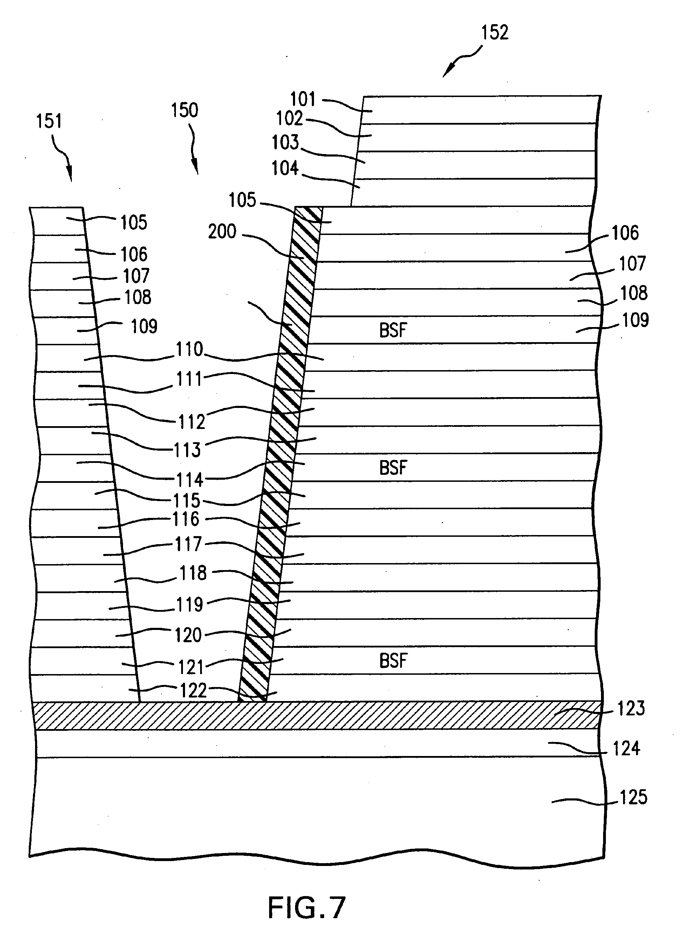

FIG. 7 is a cross-sectional view of the solar cell of FIG. 6 after the next process step according to the present invention in which a portion of the dielectric layer 200 is removed so that the step portion of the window layer is 106 is exposed, as well as layer 101;

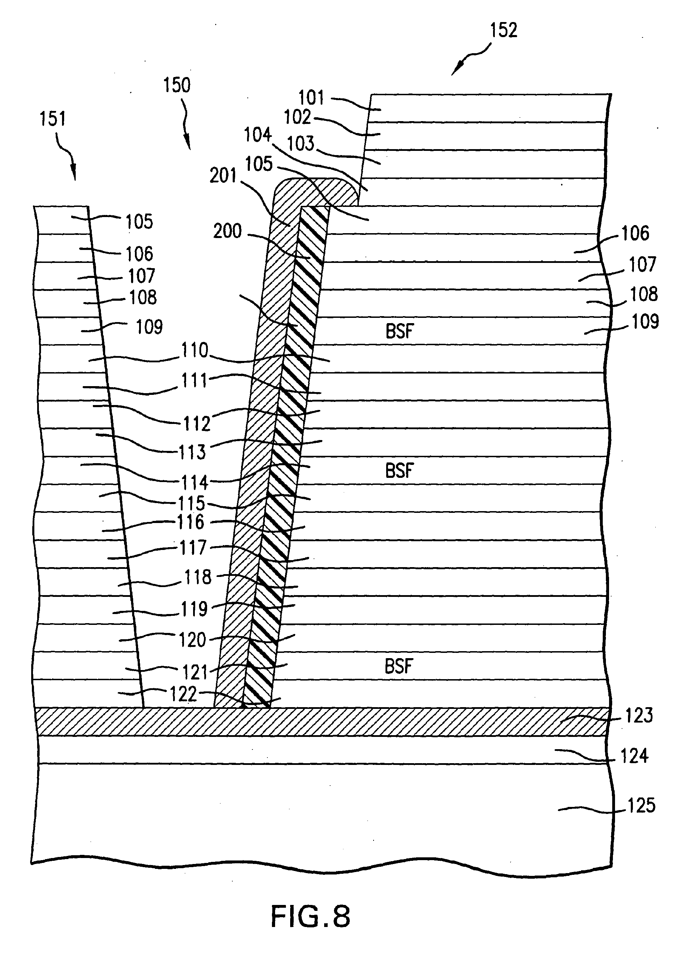

FIG. 8 is a cross-sectional view of the solar cell of FIG. 7, after the next process step according to the present invention in which a conductive layer 201 is deposited for electrically connecting the window layer 106 and the metal layer 123;

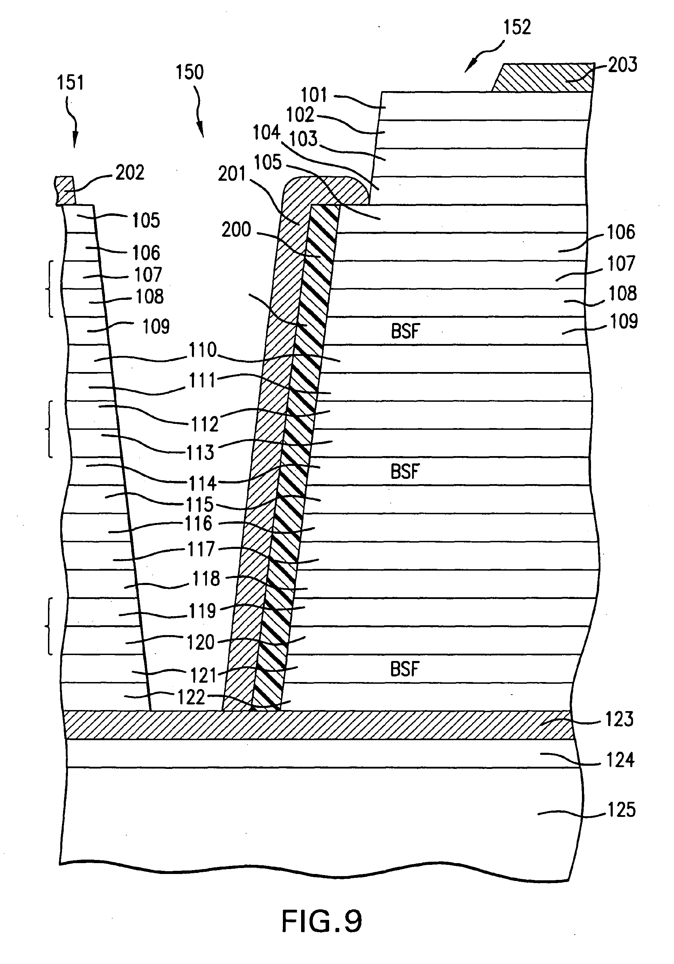

FIG. 9 is a cross-sectional view of the solar cell of FIG. 8 after the next process step according to the present invention in which contact layers 202 and 203 are deposited on the left side and right side regions 151 and 152 respectively.

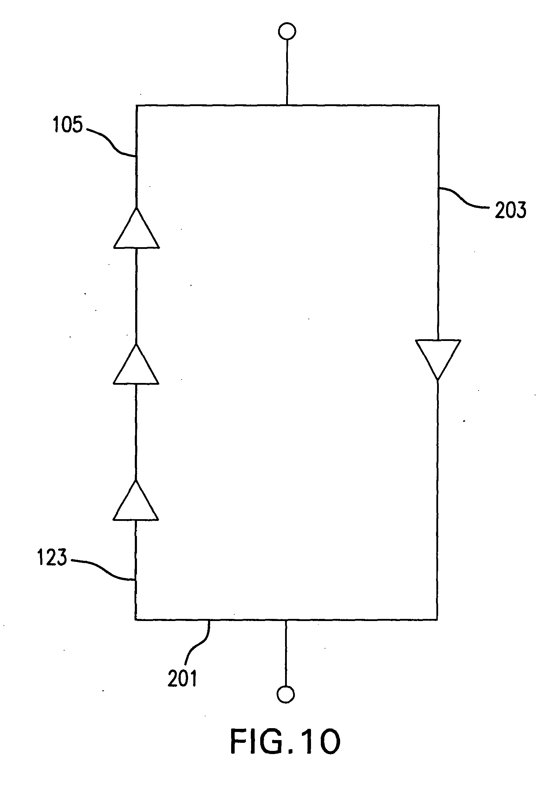

FIG. 10 is a circuit diagram of the solar cell and bypass diode according to the present invention. The cells A, B, C are arranged in the same order as shown in FIG. 9, with the layer 105 at the top of the semiconductor structure forming a terminal of the solar cell, and being electrically connected to lay 203, the terminal of the bypass diode. (Such connection is not shown in FIG. 9).

Similarly, on the back side of the solar cell, the layer 123 forms the terminal, and is connected by conductor 201 to the terminal of the bypass diode.

## Claims

1. A method of manufacturing a solar cell comprising:
providing a first substrate;
depositing on said substrate a sequence of layers of semiconductor material, including a first region in which said sequence of layers forms a bypass diode to pass current when the solar cell is shaded, and a second region spaced apart from said first region in which the sequence of layers of semiconductor material forms at least one cell of a multijunction solar cell;
providing a second substrate over said sequence of layers; and
removing said first substrate.

2. A method of manufacturing solar cell as defined in claim 1, wherein said depositing step comprises:
forming a first solar subcell having a first band gap;
forming a second solar subcell over said first subcell having a second band gap smaller than said first band gap; and
forming a third solar subcell over said grading interlayer having a fourth band gap smaller than said second band gap.

3. A method of manufacturing a solar cell as defined in claim 1, wherein said first substrate composed of GaAs.

4. A method of manufacturing a solar cell as defined in claim 2, wherein said first solar subcell is composed of an InGa(Al)P₂ emitter region and an InGa(Al)P₂ base region, said second solar subcell is composed of an InGa P₂ emitter region and GaAs base region, and said third solar subcell is composed of n type GaInAs emitter and a p type GaInAs base.

5. A method of manufacturing a solar cell as defined in claim 2, wherein said grading interlayer is composed of a plurality of layers of InGaAlAs with monotonically increasing lattice constant.

6. A method of manufacturing a solar cell as defined in claim 2, further comprising depositing a contact layer over said third solar subcell.

7. A method of claim 1, wherein the sequence of layers that forms said bypass diode is subsequently grown after the growth of the sequence of layers that forms the multijunction solar cell.

8. A method of claim 1, further comprising depositing a metal layer to connect a region of first polarity of the solar cell with a region of a second polarity of said bypass diode.

9. A solar cell semiconductor device comprising:
a sequence of layers of semiconductor material, including a first region in which the sequence of layers of material forms at least one cell of a multijunction solar cell, and a second region in which the corresponding sequence of layers forms a support for a bypass diode to protect said cell against reverse biasing, wherein the sequence of layers in the first region forming said at least one cell and the sequence of layers in the second region forming the support to said bypass diode are identical and wherein each layer in the first region has substantially the same composition and thickness as the corresponding layer in the second region;
said sequence of layers including a discontinuous lateral conduction layer for making a first electrical contact to an active region of said solar cell in one region, and a second electrical contact to an active region of said bypass diode in said second region;
a conductive layer deposited on said sequence of layers; and
a conductor connecting said second electrical contact to said conductive layer.

10. A device as defined in claim 9, wherein the multijunction solar cell includes a InGa(Al)P₂ top cell, a GaInP₂/GaAs middle cell, and a GaInAs bottom cell.
